Europäisches Patentamt

(19) European Patent Office

Office européen des brevets

(11) EP 0 964 243 A1

(12) EUROPEAN PATENT APPLICATION

(43) Date of publication:
15.12.1999 Bulletin 1999/50

(51) Int. Cl.$^6$: G01N 21/35, G01R 31/26

(21) Application number: 98870134.8

(22) Date of filing: 10.06.1998

(84) Designated Contracting States:
AT BE CH CY DE DK ES FI FR GB GR IE IT LI LU
MC NL PT SE
Designated Extension States:
AL LT LV MK RO SI

(71) Applicant: Universiteit Gent
9000 Gent (BE)

(72) Inventors:
• De Gryse, Olivier
8700 Tielt (BE)
• Rossou, Ludo
2160 Wommelgem (BE)

• Clauws, Paul
9052 Gent (Zwijnaarde) (BE)
• Van Landuyt, Joseph
2660 Antwerpen (BE)
• Vanhellemont, Jan
2970 Schilde (BE)

(74) Representative:
Bird, William Edward et al
Bird Goen & Co.,
Termerestraat 1
3020 Winksele (BE)

(54) **Method of determining an impurity concentration in highly doped semiconductor materials**

(57) A method of determining the concentration of an impurity having a vibration mode in a doped semiconductor substrate is described including the following steps:

Step 1: thinning the substrate to a thickness of 50 microns or less to form a mirror polished planar test sample, and
Step 2: determining the light radiation absorption of the test sample in a frequency range including an absorption peak related to the impurity by transmission measurements of the light radiation through only the test sample.

The method further comprises the steps of:

determining the absorption spectrum of the impurity in the frequency range, and
determining a property which is proportional to the concentration of the impurity from the absorption spectrum.

FIG. 5

## Description

FIELD OF THE INVENTION

The present invention relates to a procedure to evaluate a semiconductor single crystal. More specifically the present invention relates to a procedure to prepare a semiconductor specimen and evaluate the concentration of an impurity. More specifically the present invention relates to a procedure to prepare a highly doped semiconductor single crystal silicon specimen and evaluate the concentration of interstitial oxygen and/or precipitated oxygen. The method in accordance with the present invention is particularly useful for use as a quality control test.

TECHNICAL BACKGROUND

For low- and moderately doped material, a standard technique to measure the interstitial oxygen ($O_i$) is infrared spectroscopy. The $O_i$ concentration ($[O_i]$) is determined by measuring the height of the absorption peak due to the local vibration mode of interstitial oxygen at room temperature (RT) and multiply this by a factor (see the article I-OC88: $F_{RT}$ = 3.14 x $10^{17}$ cm$^{-3}$ ± 0.09 x $10^{17}$ cm$^{-3}$), i.e. $[O_i]$ = $F_{RT}$ x $\alpha$(1107 cm$^{-1}$)

For highly doped material, however, the material is much less transparent in the mid-infrared frequency region, because of the dominant free carrier absorption. Other techniques have been developed to measure the oxygen content in the bulk, like GFA (Gas Fusion Analysis), SIMS (Secondary Ion Mass Spectroscopy) PL (Photo Luminescence) and a FT-IR (Fourier Transform Infrared Spectroscopy) technique. For GFA silicon samples are inserted in a graphite crucible, together with high-purity nickel as a metal flux, and are melted at 2000 °C. The oxygen is then detected as CO-gas. GFA does not need to be calibrated against other techniques as it is an absolute method. An important disadvantage of GFA is that the method measures the concentration of the total oxygen present in the sample, regardless of its configuration. Therefore it is impossible, for instance, to determine the oxygen concentration precipitated during an annealing procedure, given the initial oxygen concentration. GFA however is a method with fair reproducibility.

In SIMS the sample is sputtered by an ion-beam and the secondary ions are analysed with a mass spectrometer. Before the measurement, the sample needs to be heated in a high vacuum at around 100°C to remove the adsorbed water. The oxygen level in the residual gas needs to be negligibly small. This is checked by including a float-zone specimen with low oxygen content. In each test sequence, an additional high resistivity sample with known oxygen content is included. The $[O_i]$ of the high resistivity sample is determined by measuring the height of the absorption peak belonging to $O_i$ with FT-IR. The ratio of the known oxygen concentration to the intensity of the secondary ion peak due to $^{16}O^-$ from that specific sample is then used as calibration factor. So for each test sequence, a calibration factor is determined to reduce the effects of instrumental variations. The most important disadvantage, as with GFA, is that SIMS measures the total oxygen concentration, regardless of its configuration. Nevertheless, SIMS is a very accurate method, with reproducibility of the results better than 2%.

The PL method is based on measuring the intensity of the emission of light by oxygen agglomerates when irradiated with a laser beam (e.g. with wavelength $\lambda$=647nm). Before measuring, the sample has to be heated at 400-500°C for a period between 1 and 48 hours. Next, the sample is mounted in the measuring apparatus and cooled down to 50K or lower and the intensity of the 0.96 eV emission peak is measured. The method is calibrated against the GFA method. Therefore, the reproducibility and accuracy of this method are limited by the accuracy and reproducibility of the GFA method. Moreover this method is based on growing oxygen agglomerates by annealing at 400-500°C for a period between 1 and 48 hours and assumes that there is a functional dependence between the concentration of these agglomerates and the interstitial oxygen concentration. The deviations from the empirical relationship can be larger than 20%. It is questionable if the relation between the intensity of the 0.967 eV emission line and the interstitial oxygen content is independent of the thermal history of the sample. The method is non-destructive, which implies that a specimen can be evaluated more than one time, even after annealing sequences.

An FT-IR method to determine the oxygen concentration of a highly boron-doped mono-crystalline silicon sample with a resistivity of 0.03 $\Omega$.cm is known from the article "Low-temperature Infrared Absorption Measurement for Oxygen Concentration and Precipitates in Heavily Doped Silicon Wafers", by M. Koizuka, et alia, Materials Research Soc. Symposium Proc. Vol- 442, pages 31 to 36, 1987. A highly boron doped mono-crystalline sample is bonded on a thick mono-crystalline high resistivity float zone sample by placing the two samples on top of each other, the mirror-polished sides facing each other Then the two samples are heated at 1100 °C for 30 minutes in nitrogen ambient. In this heat treatment the two samples are bonded to each other. The highly doped part is thinned and polished to a thickness for which the sample is transparent in the mid-IR region. The sample is then cooled to 4.2 K and the height of the 1136 cm$^{-1}$ absorption peak, belonging to the anti-symmetric vibration mode of interstitial oxygen is measured. The height is a weighted superposition of the interstitial oxygen in the float-zone part and of the highly boron doped part and needs to be corrected. The concentration of interstitial oxygen is given by:

$[O_i]$ = $F_{4.2K}$ x $\alpha$(1136 cm$^{-1}$), with $F_{4.2K}$ (= 3.33 x $10^{16}$ atoms/cm$^2$) the conversion factor at 4.2 K for a resolution of

0.25 cm$^{-1}$ and using the Happ-Genzel apodisation function. In this method the Czochralski wafer part is thinned through chemical etching and/or mechanical polishing (grinding). No mention is made of how to determine the thickness of the highly doped part. A disadvantage of this method is the need for heat treatment at 1100 °C. Small oxide precipitate nuclei will dissolve when their radius lies below the critical radius at that temperature leading to an increase of $O_i$. Large pre-existing oxide nuclei on the other hand will grow in size possibly leading to a significant reduction of the interstitial oxygen content. Another drawback is that this method requires two polished wafers.

A method of determining interstitial oxygen is known from the article by Qi-Yuan Wang et alia, Semicond. Sci. Technol. Vol 12 (1997) pages 464-466, entitled "Low-temperature (10K) infrared measurement of interstitial oxygen in heavily antimony doped silicon via wafer thinning", in which a silicon wafer is thinned to 65 to 200 micrometers using boron carbide grinding fluid. The method is not suitable for measuring the interstitial oxygen in p+ doping (greater than $4 \times 10^{18}$ cm$^{-3}$) as the thickness required is much less than achievable with this mechanical thinning method. Further, reference samples are required for subtracting the lattice intrinsic absorption from the observed spectra and multiple reflections in the wafer samples were taken into account by a multiple reflection formula. These steps complicate the method and make it unsuitable for use as a quality control method particularly because it is only useful for n+ dopings and another method must be devised and used for p+ dopings.

For quality control tests it is preferable if a single test can be used for all types of semiconductor substrate and also that the method of thinning the substrate is reliable and does not result in a high rate of breakage of the test samples. Further, it is preferred if materials are consumed during the test which are not toxic or dangerous to the operatives or for the environment (for example, preferably not hydrofluoric acid) and may disposed of easily.

It is an object of the present invention to provide a method of measuring initial and/or post-heat treatment precipitated impurity concentrations in highly doped semiconductor substrates.

A further object of the present invention may be to provide a method of measuring initial and/or post-heat treatment precipitated impurity concentrations in semiconductor substrates which is suitable for quality control on the shop floor.

A further object of the present invention may be to provide a method of measuring an impurity concentration in semiconductor substrates which avoids the inaccuracies and shortcomings of the known methods.

The further object of the present invention may be to provide a method of determining the interstitial oxygen concentration in semiconductor substrates with high accuracy and high reproducibility.

A further object of the present invention may be to provide a method of determining the interstitial oxygen concentration in highly doped semiconductor substrates which uses the same method for both p+ and n+ dopings.

SUMMARY OF THE INVENTION

The present invention relates to a method of evaluating the concentration of an impurity in low resistivity semiconductor material with low transparency in the frequency region of the vibration modes related to the impurity by measuring the infrared absorption of an absorption peak related to the impurity. The method does not require a thermal pre-treatment nor calibration against another method.

The present invention may also relate to a method of evaluating the concentration of an impurity, which has an infrared-active local vibration mode, in low resistivity semiconductor material with low transparency in the frequency region of the vibration mode by measuring the infrared spectrum of a sample of the material in a certain temperature region and calculating the height or integrated absorption of an absorption peak related to a local vibration mode in the temperature region.

The present invention may relate to a method of determining the concentration of an impurity in a doped semiconductor substrate including the following steps:

Step 1: thinning the substrate to a thickness of 50 microns or less to form a mirror-polished planar test sample, and
Step 2: measuring directly on the test sample the light radiation absorption of the test sample in the frequency range including an absorption peak related to the impurity.

The test sample is preferably in a substantially mechanically stress free condition after the thinning step so that it does not break provided it is handled carefully. This may be achieved by the thinning step being a plurality of mechanical thinning steps, whereby each mechanical thinning step includes using an abrasive powder, the thinning steps after the first one being carried out with a powder grain size and to a thickness such as to eliminate the defects in the substrate caused by the first thinning step either individually or in combination. Any defects introduced by any subsequent thinning step after the first thinning step are removed by the thinning steps after the subsequent step. This procedure requires a graduated reduction in powder grain sizes as the thinning process continues.

More specifically the present invention may relate to a method of evaluating the concentration of an impurity in low-resistivity semiconductor material doped with a p-type dopant (e.g. boron) at a concentration of $10^{17}$ cm$^{-3}$ or

higher, hereafter called p$^+$ material, or doped with a n-type dopant at a concentration of 5 x 10$^{17}$ cm$^{-3}$ or higher, hereafter called n$^+$ material, by irradiating the sample in the temperature region with light which has a frequency that causes the impurity incorporated in the material to absorb the light and recording and calculating the absorption spectrum in order to determine a property which is proportional to the concentration of the impurity.

More specifically the present invention may relate to a method consisting of different consecutive steps to evaluate the concentration of interstitial oxygen in n+ or p+ monocrystalline silicon by measuring the infrared absorption at low temperature of an oxygen related peak in the region 500 cm$^{-1}$ to 2000 cm$^{-1}$.

More specifically the present invention may relate to a method consisting of different consecutive steps to evaluate the concentration of interstitial oxygen in n+ or p+ monocrystalline silicon by measuring the infrared absorption of an oxygen related peak in the region 500 cm$^{-1}$ to 2000 cm$^{-1}$ with a resolution of between 0.1 and 5, more preferably between 0.1 and 2 and most preferably between 0.1 and 1 cm$^{-1}$ and with a sample temperature between 2 K and 300 K.

More specifically the invention relates to a method consisting of different consecutive steps to evaluate the concentration of interstitial oxygen in n+ or p+ monocrystalline silicon by measuring the infrared absorption of an oxygen related peak in the region 500 cm$^{-1}$ to 2000 cm$^{-1}$ with a resolution between 0.1 and 5, more preferably between 0.1 and 2 and most preferably between 0.1 and 1 cm$^{-1}$ and with sample temperature between 2 K and 20 K.

Moreover, the present invention may relate to a method consisting of different consecutive steps to evaluate the concentration of interstitial oxygen in n+ or p+ monocrystalline silicon by measuring the height of the absorption peak associated with interstitial oxygen in the neighbourhood of 1136 cm$^{-1}$ with a resolution between 0.1 and 5, more preferably between 0.1 and 2 and most preferably between 0.1 and 1 cm$^{-1}$ and with sample temperature at 5.5-6 K.

The aforementioned methods may include preparation of the sample to be measured, recording an IR spectrum in the mid-IR frequency region of the sample, calculating the absorption spectrum and determining the height or integrated absorption of the vibration mode in the neighbourhood of 1136 cm$^{-1}$ associated with O$_i$, and multiplying the height by a factor in order to obtain the concentration of interstitial oxygen.

More specifically the aforementioned methods may include the steps of:

a first step of estimating the optimal thickness from the resistivity value and type (n or p) of the sample,
a second step of thinning of the sample in a controlled manner down to about 100 micrometer,
a third step of further thinning of the sample and mirror-polishing it to the desired thickness, e.g. less than 50 micrometer, to obtain a plane-parallel double-sided mirror-polished mono-crystalline silicon sample,
a fourth step of measuring the IR-spectrum of the sample at a temperature preferably below 8 K, and
a fifth step of evaluating the IR-spectrum and calculation of the interstitial oxygen content.

BRIEF DESCRIPTION OF THE DRAWINGS

Fig. 1 is a flow chart of the procedure embodying the invention.
Fig. 2 is a flow chart of the sample preparation.
Fig. 3 is a schematic drawing of the mounted sample.
Fig. 4 is a schematic drawing of the sample holder used for IR-measurements.
Fig. 5 is a schematic representation of the FT-IR spectrometer.
Fig. 6 is a room temperature transmission spectrum of a highly doped (boron 4.2 x 10$^{18}$ cm$^{-3}$) silicon sample with a thickness of 30.4 micrometer (full line) and a simulation of a transmission spectrum using equations 3 and 8 to 12.
Fig. 7 is a detail from the transmission spectrum shown in Fig. 6 showing the interference fringes, directly related to the thickness of the sample.
Fig. 8 is an example of an experimental absorption spectrum of a 21.47 $\mu$m thick highly boron doped (3.8 x 10$^{18}$ cm$^{-3}$) silicon sample showing the absorption peak at 1136.3 cm$^{-1}$ belonging to the anti-symmetric vibration mode of O$_i$ and a fitted fit function with fixed width and position together with the accompanying straight baseline.

DETAILED DESCRIPTION OF THE INVENTION

The present invention will be described with reference to certain embodiments and to certain drawings but the invention is not limited thereto but only by the claims. Further, the present invention will be described with reference to the measurement of oxygen in silicon semiconductors but the invention is not limited thereto. For instance, it may include the determination of oxygen in a germanium substrate or phosphorus in PSG or BPSG.

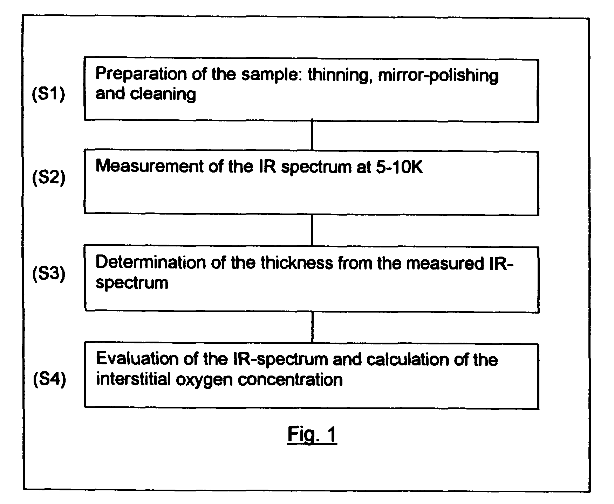

Fig. 1 is a schematic flow chart of an embodiment of the present invention. The first step (S1) is the preparation of the low resistivity monocrystalline silicon sample which includes the sub-steps of thinning, mirror-polishing and cleaning. The second step (S2) is the measurement of the infrared spectrum of the sample at a temperature below 8K.

The third step (S3) is the determination of the thickness of the sample from the measured spectrum or by other means. The fourth step (S4) is the evaluation of the infrared spectrum and calculation of the interstitial oxygen concentration.

PREPARATION OF THE SAMPLE: THINNING, MIRROR-POLISHING AND CLEANING

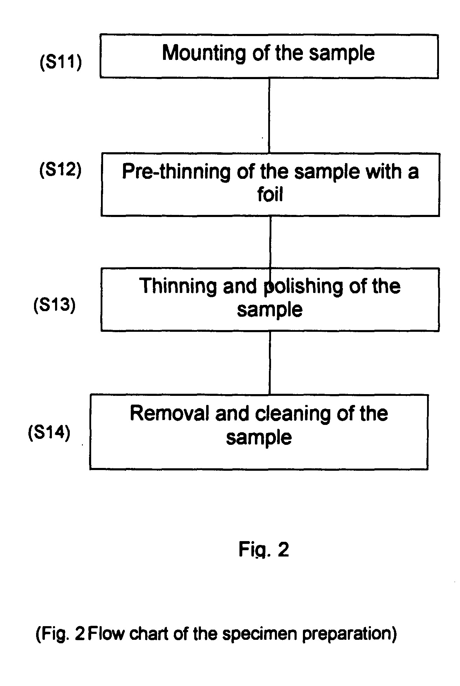

In accordance with this embodiment an initially plane parallel or non-plane parallel monocrystalline silicon sample with or without an initial mirror polished side can be prepared for an infrared absorption measurement. First one side of the sample needs to be polished in case the sample has no polished side. Next the procedure schematically shown in Fig. 2 is applied.

Fig. 2 is a flow chart of the sample preparation. (S11) A first sub-step is the mounting of the monocrystalline silicon sample with one mirror-polished side on a holder. (S12) A second sub-step is the mechanical pre-thinning of the silicon sample using a foil. This is a course thinning before the fine thinning of the next step. (S13) A third sub-step is gradually to thin and mirror-polish the sample to the optimal thickness. (S14) A fourth sub-step is to remove the sample from the holder and to clean the sample.

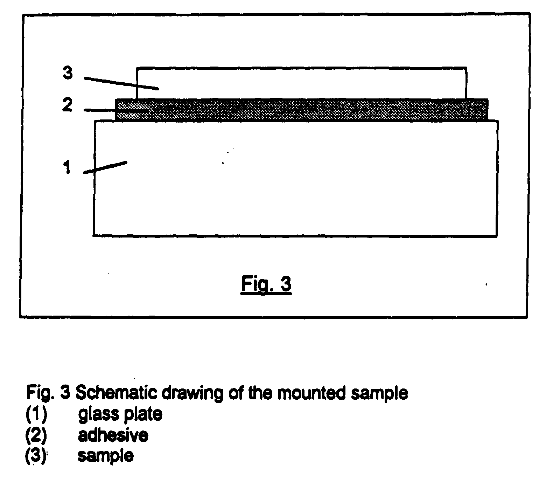

Fig. 3 is a schematic drawing of a preferred example of a mounted sample 3 ready for thinning. The lateral dimensions of the sample 3 are arbitrary but must be sufficiently large for the absorption measurements to be carried out. In this and in further examples the surface of the sample is, for instance, a square with edge size 8-mm. Hence, a square monocrystalline silicon sample 3 of edge size 8-mm is mounted on a flat holder (e.g. a glass plate) 1 by means of an adhesive 2. The adhesive is preferably strong, resistant to water but dissolvable in a solvent. However, other adhesives 2 may be used which allow removal of sample 3 and can be subsequently removed from sample 3, e.g. UV-releasable adhesives. Preferably, a resin is used as adhesive 2 when the sample has no polished side. In case one side of the sample is already mirror polished a low viscosity cyanoacrylate adhesive, dissolvable in acetone, is preferably used. The sample 3 is put on the glass plate 1 with the mirror-polished side facing the glass plate 1. A drop of adhesive 2 is put on the glass plate 1 against the sample and, because of the low viscosity, the adhesive 2 flows under the sample 3 leaving no air bubbles between the sample 3 and the glass plate 1.

The glass plate 1 with the sample mounted thereon on is located in a device for mechanical thinning and polishing. Preferably, the thinning device allows positioning of the sample 3 in such a way that the glass plate 1 is parallel to the abrasive surface. One preferred device includes a tripod with feet individually adjustable by micrometer screw threads. Such a device is available from South Bay Technology Inc. San Clemence, California, USA and is sold under the name Model 590 Tripod Polisher™. This device includes a micrometer on each leg of the tripod which can be used to accurately determine how much is removed from the sample at each thinning step and also to maintain a plane parallel sample. Preferably the known device is modified in order to be suitable for use with the present invention. Firstly the holder plate for the test sample may be increased in size so that it can accommodate larger samples, e.g. 8 x8 mm, and preferably at least sufficient to include a sample of 15 sq. mm or more. Secondly the holder plate is preferably made transparent so that the achieved thickness of the sample can be easily visually determined by the apparent colour of the test sample.

The thinning method in accordance with this embodiment may include the pre-thinning and final thinning and polishing steps of the mounted sample 3 in a controlled manner down to the optimal thickness. The optimal thickness depends on the resistivity of the sample - the lower the resistivity the thinner the sample must be. Mechanical polishing induces stress into the sample in a surface layer which has a depth up to three times the abrasive grain size used. To limit the depth of the stress zone the sample is pre-thinned and thinned and mirror-polished by making use of a series of abrasives with decreasing grain size. More specifically the sample is thinned and mirror-polished by making use of a series of abrasives with decreasing grain size. Abrasive diamond grains are particularly preferred.

The thinning of the sample preparation procedure may include the following sub-steps:

optionally thinning the sample to a thickness of 200 micrometer with a diamond grain size of 20-30 micrometer, additionally or alternatively thinning the sample to a thickness of 100 micrometer with a diamond grain size of 6-12 micrometer.

The polishing steps of the sample preparation procedure may include: polishing of the sample 3 on a foil with a diamond grain size of 6 micrometer to a thickness of 25 micrometer thicker than the desired thickness of the sample 3, polishing of the sample 3 on a foil with a diamond grain size of 3 micrometer up to a thickness within 10-15 micrometer of the desired thickness of the sample, polishing of the sample 3 on a foil with a diamond grain size of 1 micrometer up to a thickness within 5 micrometer of the desired thickness of the sample, optionally polishing of the sample 3 on a foil with a diamond grain size of 0.5 micrometer up to around the desired thickness of the sample, and optionally polishing of the sample 3 on a cloth with a diamond-emulsion to remove the final scratches.

It should be understood that the sample 3 should be thinned and polished so that it is plane parallel to within $\pm$ 10% of the thickness across the sample 3, more preferably $\pm$ 5%.

The fourth major step (step S14 of Fig. 2) is to remove the thinned and double-sided mirror-polished sample 3 from the glass plate 1. When an acetone soluble adhesive 2 has been used, the sample holder with glass-plate 1 and the sample 3 are placed in a solvent bath, e.g. acetone, until the sample 3 is released from the glass plate 1. The released sample 3 can be handled with a brush and conserved in a recipient containing a fluid (e.g. isopropyl alcohol, ethyl alcohol) in order to protect the sample from shocks.

## MEASUREMENT OF THE INFRARED SPECTRUM AT 5-10K

In accordance with the present invention an IR-measurement of the thin polished monocrystalline silicon sample 3 which is heavily doped ($10^{17}$ cm$^{-3}$ or higher) is recorded at low-temperature in order to determine the interstitial oxygen concentration, present in the sample. More specifically an IR-measurement below 8K is taken of a prepared specimen in order to determine the interstitial oxygen, present in the sample. Next, the procedure of mounting the specimen and recording an IR-spectrum of the sample will be described.

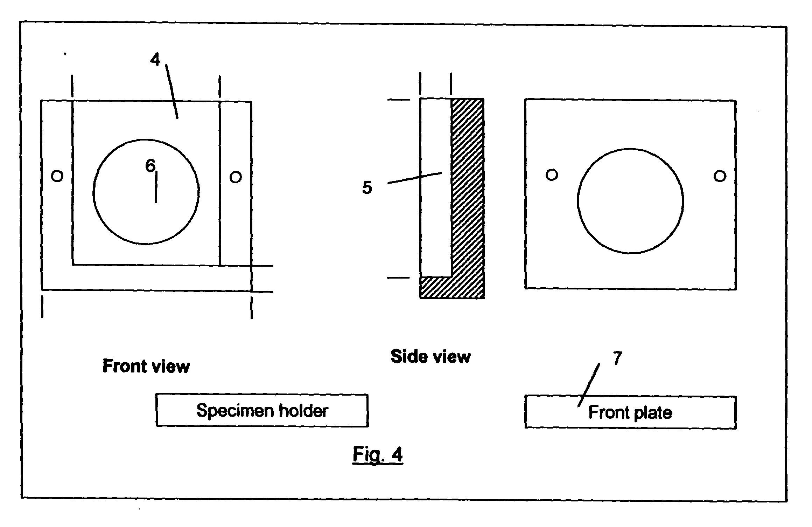

With reference to Fig. 4, the thin polished sample 3 of edge size 8-mm is mounted in a holder 4. To take into account the different thermal expansion coefficient of silicon and of the material of the holder (e.g. brass) one edge size of the holder is made slightly larger (e.g. 9-mm) than the edge size of the sample (e.g. 8-mm). The sample 3 is placed with a wetted (e.g. with isopropyl alcohol) brush in the recess 5 of holder 4. The sample 3 temporarily adheres to the holder 4 by means of the fluid (e.g. isopropyl alcohol). Finally the front plate 7 is attached to the holder 4.

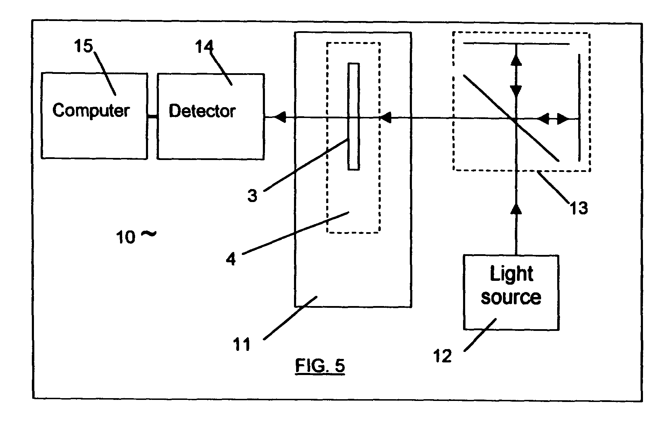

Fig. 5 is a schematic diagram of an apparatus 10 to measure an IR-spectrum of the sample 3. The sample 3 mounted in the holder 4 is placed in a He-cryostat 11. The infra-red light source 12 (e.g. a glow-bar) has an emission in the mid-IR frequency region. The light beam originating from the light source 12 enters a Michelson-interferometer 13, passes the monocrystalline silicon sample 3 held at low temperature and is detected by a sensitive detector 14 (e.g. MCT, i.e. a mercury, cadmium, telluride liquid nitrogen cooled detector). The signal is passed to a suitable computing device 15 such as a personal computer which stores the interferogram and calculates the frequency spectrum from the recorded interferogram.

## BRIEF OUTLINE OF THE TRANSMISSION OF LIGHT THROUGH A PLAN PARALLEL SPECIMEN AND OUTLINE OF THE DRUDE MODEL FOR CONDUCTING MEDIA

It is inconvenient in quality control measurements to have to use a reference sample to compare with the sample to be measured. Hence, in accordance with an embodiment of the present invention the concentration of interstitial oxygen is calculated from a theoretical model so that a comparison with a reference sample is not necessary. This calculation step makes the methods in accordance with the present invention quick and relatively easy to perform even in a shop floor environment.

The recorded spectrum ($I_S$) of the mounted monocrystalline silicon sample 3 is divided by the spectrum recorded without a specimen in the light path ($I_0$) in order to obtain the transmission spectrum (T) of the specimen:

$$T=\frac{I_S}{I_0} \qquad \text{Equation 1}$$

The transmission spectrum then has to be transformed in order to obtain the absorption spectrum. In case the interference fringes are resolved (i.e. particularly for the *in situ* thickness measurement described later) the relationship between the transmission (T) and the absorption ($\alpha$) is given by:

$$T(\sigma)=\frac{(1-R(\sigma))^2}{R(\sigma)^2.e^{-\alpha(\sigma).d}+e^{\alpha(\sigma).d}-2.R(\sigma).\cos(4.\pi.n.\sigma.d)} \qquad \text{Equation 2}$$

where $\sigma$ represents the wavenumber [cm$^{-1}$], $\alpha$ the wavenumber dependent absorption coefficient [cm$^{-1}$], R the wavenumber dependent reflection coefficient and, n the index of refraction and d the sample thickness of the mono-crystalline silicon sample.

In case the interference fringes are not resolved (typical for the measurement of the absorption peak) the transmission equation is given by:

$$T(\sigma)=\frac{(1-R(\sigma))^2.e^{-\alpha(\sigma).d}}{1-R(\sigma)^2.e^{-2.\alpha(\sigma).d}}, \qquad \text{Equation 3}$$

From equation 3 the absorption spectrum (a) is calculated by:

$$\alpha(\sigma)=\frac{-1}{d}.\ln\left\{\frac{\sqrt{[1-R(\sigma)]^4+4.R(\sigma)^2.T(\sigma)^2}-[1-R(\sigma)]^2}{2.R(\sigma)^2.T(\sigma)}\right\}\ [cm^{-1}] \qquad\text{Equation 4}$$

The present inventors have found that particularly at high doping levels, i.e. those which produce a resistivity of 30 mohm.cm or less, the absorption due to free carriers is dominant and the intensity of multiple reflected beams is negligibly small so no correction for multiple reflections is necessary. This is the case for the 10 $\mu$m frequency region if the interference fringes vanish. In this case the transmission equations 2 and 3 reduce to:

$$T=(1-R)^2.e^{(-\alpha.d)} \qquad\text{Equation 5}$$

The absorption may be deduced from the above formula as follows:

$$\alpha=\frac{\ln(1-R)^2}{d}-\frac{1}{d}.\ln(T) \qquad\text{Equation 6}$$

The first term deals with the reflections from the surfaces of the sample and only determines the position of the baseline (see later) in accordance with the present invention. The second term is the important term and includes the information of the local vibration mode of interstitial oxygen. In accordance with an aspect of the present invention, the first term of Equation 6 is ignored. Moreover in case equation 5 applies, imperfections of the surface of the specimen or a thin layer of oxide on the surface of the specimen do not influence the absorption due to the interstitial oxygen. This is a significant advantage of the method in accordance with the present invention as it means that even if the mirror polishing is not perfect or the test samples slowly grow an oxide film this will not affect the measurement seriously. It is for this reason that the last two polishing steps of the above method are optional. Further, and for the same reason, in accordance with the present invention it is not necessary to remove the oxide layer which automatically forms on the surface of the polished sample. This oxide layer will be called the residual oxide layer in accordance with the present invention. Leaving the residual oxide layer in place while still obtaining accurate results avoids a dipping process in HF solution.

The total absorption ($\alpha$) consists of components due to free carriers ($\alpha_{fc}$), due to lattice phonons ($\alpha_l$) and due to the vibration modes originating from interstitial oxygen($\alpha_{O_i}$) and may be represented by:

$$\alpha(\sigma)=\alpha_{fc}(\sigma)+\alpha_l(\sigma)+\alpha_{O_i}(\sigma) \qquad\text{Equation 7}$$

The reflection coefficient and the absorption coefficient due to free carriers can be calculated according to the Drude model for conducting media, which is given by the following dielectric functions:

$$\epsilon=\epsilon'+i.\epsilon'' \qquad\text{Equations 8}$$

$$\epsilon'=\epsilon_0-\frac{e^2.N}{\epsilon_0.m^*}.\frac{\tau^2}{1+(\omega.\tau)^2}$$

$$\epsilon''=\frac{e^2.N}{\epsilon_0.m^*}.\frac{\tau}{\omega.[1+(\omega.\tau)^2]}$$

where $\epsilon_0$ represents the permittivity of free space (= 8.85 x $10^{-12}$ F/m).
The relationship between the wavenumber and the pulsation $\omega$ is given by:

$$\omega=2.\pi.c.\sigma \qquad\text{Equation 9}$$

$$c : \text{speed of light } (3.10^{10}\ cm.s^{-1})$$

The parameters **N**, m* and $\tau$ are the density of the free carriers [m$^{-3}$], their effective optical mass [kg], and their average relaxation time [s]. The refractive indices are related to the dielectric functions by the following relations:

$$n(\sigma)=\sqrt{\frac{\sqrt{\in'(\sigma)^2+\in''(\sigma)^2}+\in'(\sigma)}{2}}$$

Equations 10

$$\kappa(\sigma)=\sqrt{\frac{\sqrt{\in'(\sigma)^2+\in''(\sigma)^2}-\in'(\sigma)}{2}}$$

The absorption due to the free carriers is then given by:

$$\alpha_{fc}(\sigma)=4.\pi\kappa(\sigma).\sigma$$

Equation 11

and the reflection coefficient R(σ) is given by:

$$R(\sigma)=\frac{[n(\sigma)\text{-}1]^2+\kappa(\sigma)^2}{[n(\sigma)+1]^2+\kappa(\sigma)^2}$$

Equation 12

in which:

n( σ) represents the index of refraction of the monocrystalline silicon sample, calculated with the Drude model and κ(σ) represents the extinction coefficient of the silicon sample, calculated with the Drude model.

ESTIMATION OF THE OPTIMAL THICKNESS

Two conflicting trends have to be taken into account when estimating the optimal thickness of the sample. In order to detect the absorption peak belonging to the local vibration mode of $O_i$ the product $\alpha \times d$, with $\alpha(1136.3 \text{ cm}^{-1})$ the height of the absorption at 1136.3 cm$^{-1}$ and d the thickness of the sample, must exceed a certain value, for example: $\alpha(1136.3 \text{ cm}^{-1}) \times d \geq M$ , with M ~ 0.01. This gives the minimum thickness $d_{min}$. On the other hand the sample needs to be thin enough, in order to be transparent in the 10 μm-region. Moreover the signal to noise ratio will improve with decreasing thickness. The transmission spectrum due to the free carriers of a highly doped monocrystalline silicon sample with a given thickness and a given resistivity can be simulated by the Drude model (Equation 8 to 12 above). The material parameters can be taken from the literature or can be determined from a transmission spectrum of a sample with known thickness. With the material parameters inserted in the equations of the Drude model (Equations 8 to 12 above) the thickness for which a sample is transparent can be calculated using equations 2 or 3.

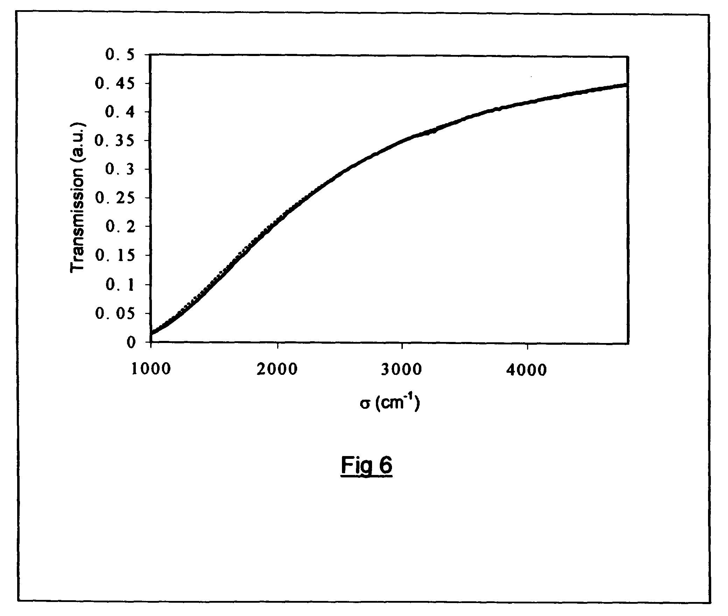

Fig. 6 is schematic representation of an experimental transmission spectrum at room temperature of a 18mΩ.cm boron doped silicon sample (full line) together with a simulation of that transmission spectrum using Equations 3 and 8 to 12 above (dashed line). From the height of the transmission peak at 1136 cm$^{-1}$ the maximum thickness of the sample ($d_{max}$) can be estimated. Although the height is device dependent the value T(1136 cm$^{-1}$)= 0.025 is preferred. A lower value will still allow recording a spectrum, but the noise level may be higher.

In this way a thickness between $d_{min}$ and $d_{max}$ may be selected if the resistivity and the accompanying parameters of the Drude model are known.

DETERMINATION OF THE EFFECTIVE THICKNESS OF THE SAMPLE FROM THE MEASURED IR-SPECTRUM

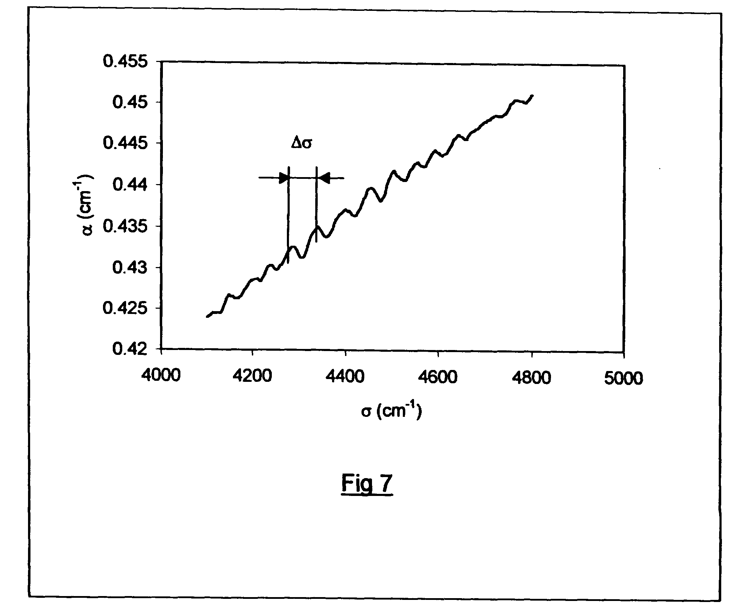

The effective thickness of the sample is measured in accordance with one embodiment of the present invention *in situ* this means in the same equipment as used for the measurement of the interferogram and without having to move the sample. Fig. 7 is a representative transmission spectrum of intensity against σ at room temperature of a 18 mΩ.cm boron doped silicon sample. In accordance with an embodiment of the present invention the thickness of the sample 3 can be determined from this spectrum. However, alternative methods of thickness measurement are included with the present invention. The light passing through a plane-parallel specimen undergoes multiple internal reflections in the low absorbing frequency region. This will result in variations in intensity in the measured spectrum as shown in Fig. 7.

The average of the period of the interference fringes (〈Δσ〉)along the σ axis is determined and the thickness is calculated as follows :

$$d = \frac{1}{2.n.\langle \Delta\sigma \rangle}$$

Equation 13

d :  thickness(cm)

n :  index of refraction (= 3.39 for silicon at low temp.)

$\langle \Delta\sigma \rangle$ :  spacing between interference fringes(cm$^{-1}$)

## DETERMINATION OF THE INTERSTITIAL OXYGEN CONCENTRATION

In accordance with the present invention the transmission spectrum is related to the absorption spectrum by equation 6. Substituting equation 7 into equation 6 we obtain:

$$\alpha = \frac{\ln(1-R)^2}{d} - \frac{1}{d}\cdot\ln(T) = \alpha_{fc}(\sigma) + \alpha_l(\sigma) + \alpha_{O_i}(\sigma) \qquad \text{Equation 14}$$

In accordance with the present invention it has been found for thin samples (less than 50 micron) the lattice term may be ignored. Rearranging equation 14 we obtain:

$$\alpha_{Oi}(\sigma) = \frac{\ln(1-R)^2}{d} - \alpha_{fc}(\sigma) - \frac{1}{d}\cdot\ln(T)$$

Once the absorption spectrum has been calculated from this equation the absorption peak belonging to the local vibration mode of $O_i$ at 1136.3 cm$^{-1}$ may be determined. The height of this peak can then be multiplied by a conversion factor yielding the interstitial oxygen concentration.

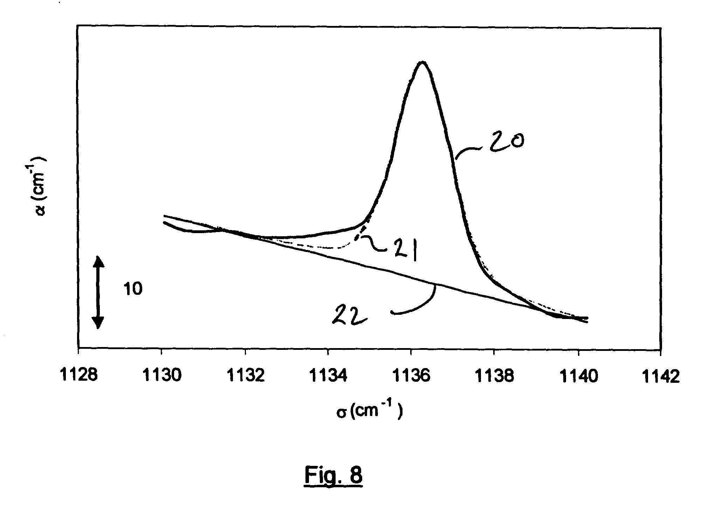

In accordance with one embodiment of the present invention, the last equation above is solved in the following manner. The third term on the right hand side includes a logarithmic transformation of the transmission results and is therefore calculated from the measured transmission spectrum and the measured thickness. The first two terms on the right hand side are approximated by a straight line - the baseline 22. The shape 20 of the absorption peak at 1136.3 cm$^{-1}$ may be fitted to the baseline 22 and a lineshape function 21 as shown schematically in Fig. 8. The fit may be carried out using any suitable mathematical curve fitting method, for example a non-linear least squares technique. The Levenberg-Marquard curve fitting procedure is suitable. Fig. 8. shows an example of an experimental absorption spectrum of a 21.47 μm thick highly boron doped (3.8 x 10$^{18}$ cm$^{-3}$) silicon sample showing the absorption peak at 1136.3 cm$^{-1}$ belonging to the anti-symmetric vibration mode of $O_i$ (full line) and a best-fit function (dotted line) to the spectrum with fixed width and position together with the accompanying straight baseline. The lineshape 21 may be include Lorentzian or Gaussian functions or a combination of both.

The combined Lorentzian and Gaussian function for the lineshape is given by:

$$I(\sigma) = A\cdot\left[\frac{w}{\frac{4}{\delta^2}\cdot(\sigma-\sigma_0)^2+1} + (1-w)\cdot\exp\left(-\frac{4\cdot\ln(2)}{\delta^2}\cdot(\sigma-\sigma_0)\right)\right]$$

where A represents the height, δ the full width at medium height, $\sigma_0$ the peak position and w the weight of the Lorentzian part of the fit-function. For a resolution of 1 cm and Blackman-Harris 3-Term apodisation function the following parameters have been used successfully to determine the lineshape function 21:

| Lineshape | 35% Lorentzian + 65% Gaussian |
|---|---|
| Position | 1136.3 cm$^{-1}$ |
| Frequency Width at Medium Height | 0.65 ± 0.01 cm$^{-1}$ |

Only the height of the fit function and the parameters of the straight baseline 22 are free parameters. These are determined by the best fit procedure mentioned above. The height (or the integrated intensity) of the fitted function is proportional to the interstitial oxygen concentration:

$$[O_i] = F_{RT} \times H \times \alpha(1136.4 cm^{-1}) \ [cm^{-3}],$$

where $F_{RT}$ represents the conversion factor for interstitial oxygen for room temperature (see IOC-88: $F_{RT} = 3.14 \times 10^{17}$. $cm^{-2}$), and H the ratio of the height of the peak at 1107 $cm^{-1}$ at room temperature to the height of the absorption peak at 1136.3 $cm^{-1}$ at 5.5K. For a resolution of 1 cm and when a Blackmann-Harris 3-term apodisation function is used the conversion factor H below 8 K is given by:

H = 0.074 ± 0.005. The accuracy of the measurement may be estimated by calculating the root mean square of the noise in the region 1150-1120 $cm^{-1}$ ($\sigma_N$), excluding the peak.

An estimation of the total accuracy may be determined by summing the square of the relative standard deviations of the measurement ($\sigma_N$) and of the conversion factors H ($\sigma_H = 0.07$) and F ($\sigma_F = 0.03$):

$$\sigma = \sqrt{\sigma_N^2 + \sigma_H^2 + \sigma_F^2}$$

Table 1

| Sample Name | S1 | S2 | S3 | S4 |
|---|---|---|---|---|
| Thickness (cm) | $30 \times 10^{-4}$ | $21.5 \times 10^{-4}$ | $13.8 \times 10^{-4}$ | $27.4 \times 10^{-4}$ |
| Resistivity (mΩ Cm) | 18.6 | 18.8 | 8.7 | 26.4 |
| Dopant material | Boron | Boron | Boron | Antimony |
| $\alpha$(1136.3) ($cm^{-1}$) | $23.5 \pm 2.8$ | $30.7 \pm 0.3$ | $29 \pm 4$ | $28.4 \pm 0.9$ |
| $[O_i]$ ($\times 10^{17}$ $cm^{-3}$) | $5.5 \pm 0.8$ | $7.1 \pm 0.6$ | $6.7 \pm 1.0$ | $6.60 \pm 0.6$ |
| $[O_i]$ ($\times 10^{17}$ $cm^{-3}$) GFA | 5.5 | 8 | 6.9 | 6.87 |
| Relative deviation between the two methods | 0 | 0.11 | 0.03 | 0.04 |

Table 1 is a an example of the present invention showing results of low resistivity monocrystalline silicon samples measured in accordance with the method of the present invention. The first three examples (S1, S2, S3) are boron doped monocrystalline silicon samples. For the sample thicknesses used, the interference fringes in the frequency region of 1136 $cm^{-1}$ have vanished totally due to the strong absorption and equation 6 can be used to determine the height of the absorption peak around 1136 $cm^{-1}$.

The third example (S3) is a 8.7 mΩcm boron doped sample. Since the dopant concentration is very high the thickness must be reduced considerably, e.g. preferably to 20 micron or less. It can be seen that for the thicknesses used for the first and the third specimens the noise level is slightly higher.

The fourth example (S4) is an n-type silicon sample doped with antimony. The thickness of this sample is much smaller than the thickness when it becomes transparent leading to the occurrence of interference fringes. This necessitates the use of the transmission equation 2 or 3 to determine $[O_i]$. Good agreement with GFA analysis is obtained with both samples.

Table 2

| Sample Name | S1 | S2 |
|---|---|---|
| Thickness (cm) | $19 \times 10^{-4}$ | $26.37 \times 10^{-4}$ |
| Resistivity (mΩ Cm) | 18.3 | 18.8 |
| Dopant material | Boron (B) | Boron (B) |
| $\alpha$(1136.3) ($cm^{-1}$) | $5.4 \pm 1.3$ | $8.7 \pm 0.6$ |
| $[O_i]$ ($\times 10^{17}$ $cm^{-3}$) | $1.3 \pm 0.3$ | $2.0 \pm 0.14$ |
| $\Delta[O_i]$ ($\times 10^{17}$ $cm^{-3}$) | 4.2 | 5.1 |

Table 2 is a practical example of the measurement of the interstitial oxygen in highly boron doped silicon samples after a heat treatment using the method in accordance with the present invention. The samples used are equivalent samples to the first two samples described with reference to table 1. To determine the concentration of oxygen precipitated during annealing of a semiconductor sample, the following steps may be carried out in accordance with a further embodiment of the present invention. A 2-mm thick specimen is cut in two 1-mm thick pieces. The first is thinned, polished and measured as previously described (table 1). The second half receives a heat treatment (16h at 500°C + 16h at 800°C + 8h at 1050°C in Ar) followed by the procedure in accordance with the present invention to measure the interstitial oxygen concentration. The difference between the interstitial oxygen concentration before and after annealing equals the concentration of the oxygen precipitated during the heat treatment. Since the preparation of the samples do not need any heat treatment (advantage of the present invention), the thermal history of the sample will not be influenced by the sample preparation procedure. The difference between the $[O_i]$ of the two sample thus gives a direct result of the precipitated oxygen.

It will be appreciated that the method described above requires no comparison samples to allow for the lattice absorption, nor is there a need to allow for multireflection effects explicitly. The method is insensitive to defects in the surface of the test sample such as scratches or an oxide layer and all the measurements and calculations can be made (including the thickness measurement of the sample) with the sample in one place, i.e. in the interferometer arrangement. This means that the sensitive samples are kept in one place reducing the risk of breakage and providing a compact measurement arrangement suitable for quality control purposes.

While the invention has been shown and described with reference to preferred embodiments, it will be understood by those skilled in the art that various changes or modifications in form and detail may be made without departing from the scope and spirit of this invention as defined in the attached claims. In particular the present invention includes mirror polishing one major surface of a planar sample, depositing a reflecting metal layer on this surface, attaching the sample to a suitable holding substrate, thinning and mirror polishing the other major surface in accordance with the method described above or another suitable method and then measuring the transmission interferogram by shining the infra-red light from the side opposite from the metallised surface. The infra-red beam passes through the sample twice (due to the reflection from the metal layer) and this must be allowed for in the calculation of the appropriate thickness. This procedure makes thinning of the substrate easier as a holding substrate may be used to support the thin sample, however the thinning must be done to half the thicknesses mentioned above, that is down to say 4 micron for very heavily doped samples.

## Claims

1. A method of determining the concentration of an impurity having a vibration mode in a doped semiconductor substrate including the following steps:

   Step 1: thinning the substrate to a thickness of 50 microns or less to form a mirror polished planar test sample, and
   Step 2: determining the light radiation absorption of the test sample in a frequency range including an absorption peak related to the impurity by transmission measurements of the light radiation through only the test sample.

2. A method according to claim 1, further comprising the steps of:

   determining the absorption spectrum of the impurity in the frequency range, and
   determining a property which is proportional to the concentration of the impurity from the absorption spectrum.

3. A method according to claim 1 or 2, wherein the impurity is interstitial oxygen and the substrate is monocrystalline silicon.

4. A method according to claim 3, wherein the frequency range is in the infra-red region and the step of determining the property includes determining the height or integrated absorption associated with an interstitial oxygen concentration in the neighbourhood of $1136 \text{ cm}^{-1}$, and multiplying the height by a factor in order to obtain the concentration of interstitial oxygen.

5. A method according to any previous claim, wherein the semiconductor substrate is doped with a p-type dopant at a concentration of $10^{17} \text{ cm}^{-3}$ or higher or doped with an n-type dopant at a concentration of $5 \times 10^{17} \text{ cm}^{-3}$ or higher.

6. A method according to any previous claim wherein the semiconductor substrate has a resistivity of 30 milliohm.cm or less.

7. A method according to any previous claim, wherein step 2 includes measuring the infrared absorption at a temperature between 2 and 300 °K, more preferably between 2 and 20 °K and most preferably between 5.5 and 6°K, of an oxygen related peak in the frequency region 500 cm$^{-1}$ to 2000 cm$^{-1}$.

8. A method according to any of the previous claims, further comprising:

   estimating the optimal thickness for the measurement from the resistivity value and type of the substrate,
   thinning the substrate in a controlled manner down to about 100 micrometer,
   further thinning of the substrate and mirror-polishing it to the desired thickness to obtain a plane-parallel mirror-polished substrate.

9. A method according to claim 8, wherein each thinning step may include a plurality of mechanical thinning steps.

10. A method according to clam 9, wherein the each mechanical thinning step includes using an abrasive powder, the thinning steps after any one thinning step being carried out with a powder grain size and to a thickness such as to eliminate, individually or in combination the defects in the substrate caused by the one thinning step.

11. A method according to any of the claims 2 to 10, wherein the absorption spectrum determining step is carried out by fitting a lineshape and a baseline to the calculated absorption spectrum.

12. A method according to any previous claim, wherein the thickness of the sample is measured in the same equipment as is used for the transmission measurements.

13. Use of the method according to any previous claim as a quality control test.

| (S1) | Preparation of the sample: thinning, mirror-polishing and cleaning |
|------|------|
| (S2) | Measurement of the IR spectrum at 5-10K |
| (S3) | Determination of the thickness from the measured IR-spectrum |
| (S4) | Evaluation of the IR-spectrum and calculation of the interstitial oxygen concentration |

## Fig. 1

| | |
|---|---|
| (S11) | Mounting of the sample |
| (S12) | Pre-thinning of the sample with a foil |
| (S13) | Thinning and polishing of the sample |
| (S14) | Removal and cleaning of the sample |

Fig. 2

(Fig. 2 Flow chart of the specimen preparation)

**Fig. 3**

Fig. 3 Schematic drawing of the mounted sample
(1)    glass plate
(2)    adhesive
(3)    sample

**Front view**

4

6

**Side view**

5

7

| Specimen holder | | Front plate |

Fig. 4

FIG. 5

EP 0 964 243 A1

**Fig 6**

Fig 7

**Fig. 8**

European Patent
Office

**EUROPEAN SEARCH REPORT**

Application Number

EP 98 87 0134

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| D,X | M.KOIZUKA ET AL: "Low-temperature infrared absorption measurement for oxygen concentration and precipitates in heavily doped silicon wafers"<br>MATERIALS RESEARCH SOC. SYMPOSIUM PROCEEDINGS,<br>vol. 442, 1997, pages 31-36, XP002095097<br>* the whole document * | 1-7,13 | G01N21/35<br>G01R31/26 |
| D,A | WANG Q -Y ET AL: "LOW-TEMPERATURE (10K) INFRARED MEASUREMENT OF INTERSTITIAL OXYGEN IN HEAVILY ANTIMONY-DOPED SILICON VIA WAFER THINNING"<br>SEMICONDUCTOR SCIENCE AND TECHNOLOGY,<br>vol. 12, no. 4, April 1997, pages 464-466, XP000687363<br>* the whole document * | 1-7 | |
| A | A. BORGHESI A ET AL: "OXYGEN PRECIPITATION IN SILICON"<br>JOURNAL OF APPLIED PHYSICS,<br>vol. 77, no. 9, 1 May 1995, pages 4169-4244, XP000504591<br>* page 4180, left-hand column, line 36 - line 44 *<br>* page 4181, left-hand column, line 25 - line 36 * | 8 | TECHNICAL FIELDS SEARCHED (Int.Cl.6)<br><br>G01N<br>G01R |
| A | A.BORGHESI ET AL: "Interstitial oxygen determination in heavily doped silicon"<br>J.APPL.PHYS.,<br>vol. 68, no. 4, 15 August 1990, pages 16551655-1660, XP002095098<br>* page 1658, right-hand column, line 11 - page 1659, left-hand column, line 41 * | 11,12 | |

-/--

The present search report has been drawn up for all claims

| Place of search | Date of completion of the search | Examiner |
|---|---|---|
| THE HAGUE | 2 March 1999 | Verdoodt, E |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**European Patent Office**

## EUROPEAN SEARCH REPORT

Application Number

EP 98 87 0134

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | A.S.OATES, W.LIN: "Infrared measurements of interstitial oxygen in heavily doped silicon" JOURNAL OF CRYSTAL GROWTH, vol. 89, 1988, pages 117-123, XP002095099 * abstract * | 11,12 | |

TECHNICAL FIELDS SEARCHED (Int.Cl.6)

The present search report has been drawn up for all claims

| Place of search | Date of completion of the search | Examiner |
|---|---|---|
| THE HAGUE | 2 March 1999 | Verdoodt, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)